Europäisches Patentamt

European Patent Office

Office européen des brevets

(11) Publication number: **0 150 409**
**B1**

(12) **EUROPEAN PATENT SPECIFICATION**

(45) Date of publication of patent specification: **08.08.90**

(51) Int. Cl.⁵: **G 01 R 27/28, H 04 B 3/46**

(21) Application number: **84115607.8**

(22) Date of filing: **17.12.84**

(54) **Keyboard-operated RF network analyzer.**

(30) Priority: **09.01.84 US 569380**

(43) Date of publication of application:
**07.08.85 Bulletin 85/32**

(45) Publication of the grant of the patent:
**08.08.90 Bulletin 90/32**

(84) Designated Contracting States:
**DE FR GB**

(56) References cited:
**US-A-4 105 995**

**MICROWAVE JOURNAL, vol. 24, no. 4, April
1981, Dedham, Massachusetts, USA; G.R. COBB
"New software for low loss two-port
measurements", pages 63-68**

**MIROWAVE JOURNAL, vol. 26, no. 4, April 1983,
Dedham, Massachusetts, USA; J.L. MINCK
"Signal simulations, signal generators, and
signal integrity", pages 75-83**

(73) Proprietor: **Hewlett-Packard Company
Mail Stop 20 B-O 3000 Hanover Street
Palo Alto California 94304 (US)**

(72) Inventor: **Cannon, Wayne C.
6281 Anderson Road
Forestville, CA 95436 (US)**
Inventor: **Neering, Michael J.
3523 Shallow Creek Drive
Santa Rosa, CA 95404 (US)**

(74) Representative: **Patentanwälte Kohler -
Schwindling - Späth
Hohentwielstrasse 41
D-7000 Stuttgart 1 (DE)**

## Description

The present invention relates to a keyboard-operated RF network analyzer as it is used to characterize networks, including devices, components, and systems, by measuring the network's transmission and reflection coefficients versus frequency.

In general, a network analysis measurement system contains several separate modules. First is an RF source to provide a stimulus to a device under test (DUT). Second is a signal separation network for routing the stimulus to the DUT and for sampling the energy that is reflected from, or transmitted through, the DUT. Also, energy is sampled from the signal that is incident upon the DUT in order to provide a reference for all relative measurements. Third is a tuned receiver to convert the resulting signals to an intermediate frequency (IF) for further processing. In vector network analyzers both the magnitude and phase relationships of the original signals must be maintained through the frequency conversion to IF to provide usable measurements. Fourth is a detector to detect the magnitude and phase characteristics of the IF signals, and fifth is a display on which to present the measurement results.

Measurement accuracy may be improved in a computer controlled system by a process known as vector error correction where a set of calibration devices with known characteristics is measured and a set of equations is solved with the data to determine the errors associated with the network analyzer itself. This calibration model is then stored in the computer for later correction of data measured on an unknown device.

A network analyzer of this kind is known from page 444 of the 1983 Hewlett-Packard Electronic Instruments and Systems Catalog describing the Hewlett-Packard Model 8507C Automatic Network Analyzer. The operating parameters of the known instrument are settable from the keyboard of a controlling computer. Any one of the operating parameters may be changed independently from the other parameters, and there is provided a store and recall function for storing and subsequently recalling a complete set of operating parameter settings of the RF network analyzer with a single keystroke. This function may be activated by the operator at the appropriate time to save the currently active instrument state or to reactivate an instrument state previously stored by the operator.

In US—A—4,105,995 a voice channel tester is disclosed in which a measurement switch provides for the reading of a plurality of switch settings which determine a certain measuring routine. A plurality of switches allows selection of measurement parameters manually and individually for each single measurement. The application of such a setting and selection system to an automatic network analyzer as disclosed in Microwave Journal, Volume 24, No. 4 (1981), pages 63 to 68, would not result in a device which were basically different from the above mentioned Hewlett-Packard Model 8507C Automatic Network Analyzer.

In contrast thereto, it is the object of the invention to simplify the operation of prior art RF analyzers in which setting up a specific measuring routine may be a laborious and cumbersome task.

This object is met by providing an RF analyzer with apparatus which has the feature of claim 1. In this apparatus, measurement configurations are stored at different levels of a hierarchical configuration, which allows the automatic generation of machine configurations by selecting particular branches of the hierarchical tree. In the normal situation, without a hierarchical configuration, a complicated aphorism or some other approach was requied to generate a new configuration, or the configuration had to be specified by the user. Now, the user is free from having to specify the complete measurement configuration, since the instrument provides it automatically as soon as the user picks an element thereof.

In a preferred embodiment of the invention, the control panel of the RF network analyzer has a number of control keys arranged in a unique heirarchical structure to specify the complete measurement process.

Several control keys are dedicated for functions most commonly used in typical measurement applications, while less common functions are available through a series of logical menus which are accessed via several "softkeys" under control of internal firmware. Altogether, over 70 menus with over 320 functions can be reached by means of the softkeys to provide a wide range of microwave network measurements.

An embodiment of the invention will now be described in detail with reference to the accompanying drawings.

Fig. 1 shows a simplified block diagram of an RF vector network analyzer in accordance with the present invention.

Fig. 2 shows a detailed block diagram of a portion of the RF vector network analyzer shown in Fig. 1.

Fig. 3 shows the front panel controls of the RF vector network analyzer shown in Fig. 1.

Fig. 4 shows a hierarchical CPFR structure used in the RF vector network analyzer shown in Fig. 1.

Fig. 5 shows the software signal processing flow used in the RF vector network analyzer shown in Fig. 1.

Fig. 6 shows the software process controller for use in the RF vector network analyzer shown in Fig. 1.

Description of the block diagram

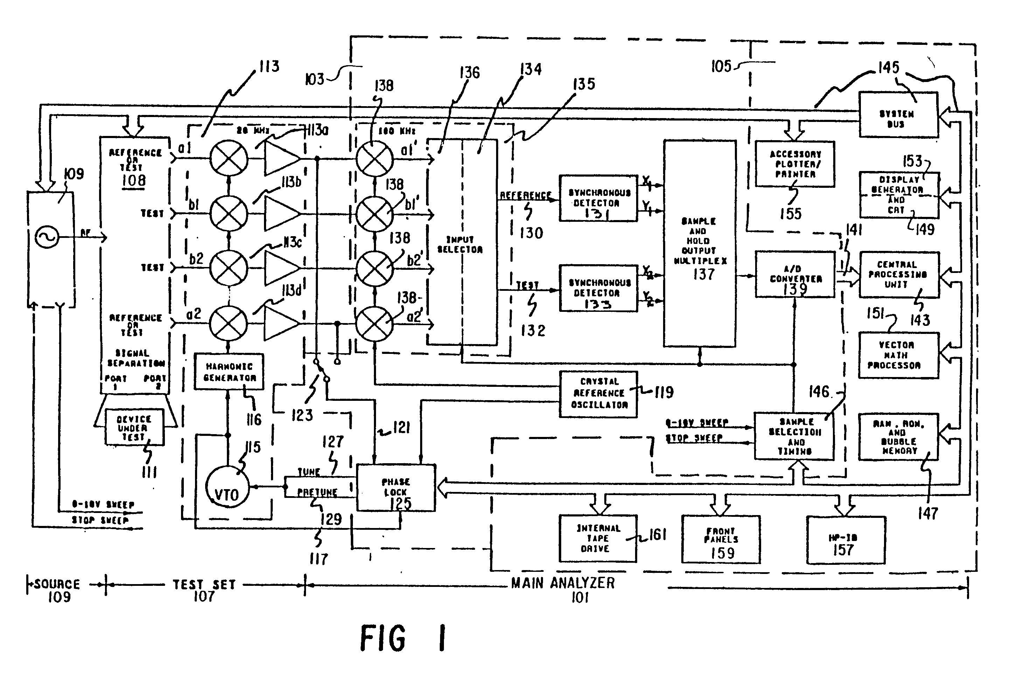

In Figure 1 there is shown a block diagram of an RF vector network analyzer system. The measurement system consists first of a main network analyzer 101 with a second IF/detector section 103 and a data processor/display section 105. The main network analyzer 101 is fed by one of four configured test sets 107 which provide signal separation circuitry 108 and first IF frequency conversion circuitry 113 for reflection/transmission (one incident signal) or S-parameter (two incident signals) measurements up to either 18 or 26.5 GHz. The frequency converter 113 alone is also available to permit the addition of user supplied signal separation devices 108 for specially configured test needs. A third main component of the measurement system is a compatible RF source 109 such as an HP 8340A synthesized sweeper, available from the Hewlett-Packard Co., Palo Alto, California, which can be used in either a stepped frequency mode, in which synthesizer class frequency accuracy and repeatability can be obtained by phase locking the source 109 at each of more than 400 frequency steps over the frequency range selected by the main analyzer 101, or the swept frequency mode for applications where extreme frequency range, high stability, and spectral purity are important such as in narrow band measurements over sweeps of less than 5 MHz. An HP 8350B sweeper with HP 83500 series RF plug-ins covering the entire desired frequency range or with lesser spans can also be used in applications where a more economical source is sufficient. Both the HP 8340A and the HP 8350B include the necessary analog interface signals as well as full digital handshake compatibility with the main analyzer 101. This digital handshake compatibility allows the main analyzer 101 to act as the controller for an entire system by directly managing the source 109 to provide all of the inputs such as start frequency, stop frequency, centering, span, and modulation, as well as constraints that the source 109 normally places on itself internally. For example, if a user by means of the main analyzer 101 requests the source 109 to sweep an incompatible frequency such as 50 GHz, the source 109 will respond to the main analyzer 101 that such a frequency cannot be accommodated and the main analyzer 101 in turn informs the user of the situation. Therefore, the user need only be concerned with his interface to the main analyzer 101 and can use any source 109 that has implemented the required handshake protocols. Because the main analyzer 101 is in control of the source 109, it is also possible to automatically select a different frequency range or more (stepped or swept) to be applied to each of the ports 1 and 2.

Integrated within each test set 107 is the first IF frequency converter 113 with three channels 113a, 113b, and 113c for reflection/transmission measurements and four channels 113a, 113b, 113c, and 113d for S-parameter measurements. RF to IF conversion is achieved through a sampling technique equivalent to harmonic mixing. An harmonic of a tunable local oscillator 115 is produced by an harmonic generator 116 to mix with the incoming RF signal to provide the first IF signal at 20 MHz for the incident signal a1 on an input port 1, the incident signal a2 on an output port 2, the reflected or transmitted signal b1 on the input port 1, and the reflected or transmitted signal b2 on the output port 2. Frequency tuning for the local oscillator 115 is controlled by a phase lock loop 117 that compares the signal a1 or a2 in the reference channel first IF to an IF reference oscillator 119 in the IF/detector section 103. Any difference between the frequency of the signal a1 or a2 in the reference channel first IF and the IF reference oscillator 119 results in an error voltage on an error voltage signal line 121 via a switch 123 that tunes the local oscillator 115 to the frequency that produces the desired first IF. Switch 123 is toggled to select the most appropriate signal a1 or a2 to lock on to based either on internal criteria within the system or as defined by the user. When using the internal criteria, if the incident signal port is port 1, a1 is selected by switch 123, and if the incident signal port is port 2, a2 is selected by switch 123. This scheme allows the local oscillator 115 to track the incoming RF when the RF frequency is changing with time as in the swept mode. The integrated test set 107 permits high RF to first IF conversion efficiency even at 26.5 GHz, making possible both high sensitivity and wide dynamic range measurements. The test set architecture eliminates the extensive RF switching needed in previous test sets, removing the significant uncertainties caused by the lack of repeatability of mechanical switches. The reflection/transmission test sets 107 require no internal switching since the fourth channel 113d is not required, and the S-parameter test sets 107 use only one electronic PIN diode switch located inside of the test set 108 such that it cannot contribute to uncertainties as it is switched prior to the ratio mode of the power splitter.

Several concepts have been incorporated in the IF/detector section 103 of the main analyzer 101 to increase the precision of IF processing and signal detection. Most of the phase lock hardware 125 in the phase lock loop resides in this section 103. Harmonic mixing number and local oscillator pretuning are controlled digitally via lines 127 and 129 and offer phase lock and tracking performance that is precisely repeatable from sweep to sweep. Before the first IF signals proportional to a1, a2, b1, and b2 are sent to synchronous detectors 131 and 133, they are down converted to a second IF at 100 KHz by mixers 138 and go through a pair of multiplexers 136 and variable gain amplifiers 134 in a second IF section 135. Amplifier gain is controlled and calibrated digitally and is varied by autoranging to optimize the second IF signal levels 130 and 132 available to the synchronous detectors 131 and 133 resulting in an order of magnitude improvement in signal to noise performance and dynamic accuracy for the detector output signals x1, y1, x2, and y2. Likewise, the synchronous detectors 131 and 133 employ a digital architecture that allows for precise control of their 90 degree phase shift function which results in improved accuracy as well as common mode rejection of local oscillator phase noise effects. Finally, the detected signals x1, y1, x2, and y2 are multiplexed with a sample-and-hold/multiplexer (MUX) 137 and then digitized by an analog-to-digital converter (ADC) 139 with 19 bits of resolution. Each ADC conversion takes approximately 40 microseconds and four readings are made for each RF frequency data point to provide the real and imaginary data for both the reference signal 130 and test signal 132.

The output of the ADC 139 is then passed on a 16 bit bus 141 to a high speed central processor (CPU) 143 which includes a microprocessor such as a Motorola 68000 as well as the associated microprocessor system interrupt and I/O control circuitry. Because the CPU 143 is integrated into the main network analyzer 101 it is possible to utilize a multitasking architecture to make more efficient use of time than has previously been possible. This architectural integration also permits substantial increases in data processing flexibility and system control performance. Via a dedicated system interface and bus 145, the CPU 143 controls the RF source 109, the test set 107, and, along with the sample selection and timing circuitry 146, all of the IF processing functions including the phase lock hardware 125, autoranging in the IF amplifiers 134, detection by the synchronous detectors 131 and 133, and digitization by the ADC 139. The CPU 143 periodically initiates a self calibration sequence for the IF amplifiers 134, synchronous detectors 131 and 133, and the ADC 139 and the resulting gain, offset, and circularity changes are stored in memory 147, so that the changes in the IF amplifiers 134 can be subtracted from measured results. The CPU 143 also performs all data processing functions for the system. The signals in the IF section 103 are detected as linear real and imaginary components of a vector quantity and the CPU 143 processes the detected data into a variety of formats for presentation on the CRT display 149. By digitally computing the various measurement formats, improvements in dynamic range and meaningful resolution are gained over traditional analog circuit processing techniques.

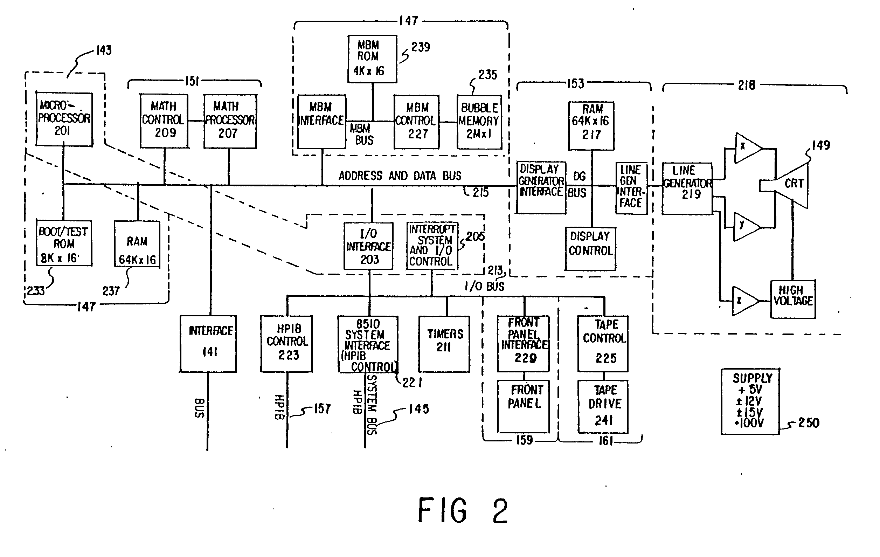

With the known network analyzer instruments, an external computer was required in order to characterize and remove systematic errors. With the present RF vector network analyzer, this capability exists internally with enough storage capacity (i.e., 256K bytes of random access memory (RAM) and 256K bytes of bubble memory) in the memory 147 to retain up to two 401 point 12-term error corrected traces of data. (Note: each byte of memory consists of eight bits of data storage.) In addition, the measured data can be converted to show the response of the DUT 111 as a function of time (time domain) using an internal Fourier transform process. All data processing takes place virtually in real time by means of parallel data processing in the CPU 143 aided by the incorporation of a dedicated, floating point, complex number, vector math processor 151 designed specifically for fast vector computations. The multiplication of two complex numbers by the vector math processor 151 requires only one operation with the product available within 20 microseconds, so that error corrected measurement results are available 1000 times faster than in the prior art. By means of an internal vector graphics generator 153, the real time processed data is then immediately presented on the CRT 149, on a digital printer/plotter 155, or via an IEEE-488 (HP-IB) interface and bus 157 to external devices. Present as well as past states of front panel controls 159, past and present traces of data, and entire system calibrations can also be stored in and recalled from the memory 147 or loaded and read from a built-in tape drive 161 by means of the system interface 203 and bus 215 (Fig. 2) under control of the CPU 143.

Integrated processor

As explained previously and shown in more detail in Figure 2, the built-in CPU 143 with a 16-bit multi-tasking microprocessor 201, I/O interface circuitry 203, and interrupt system and I/O control circuitry 205, and the vector math processor 151 including math processor circuitry 207 and math controller 209 are a key to the high speed performance of the present RF vector network analyzer. A variable precision and variable function architecture of the vector math processor 151 make it adaptable to perform both floating point and complex number math operations. The vector math processor 151 operates on a 16 MHz clock generated within microprocessor 201 and is controlled by a state machine with 1K byte of read only memory (ROM) for storage of microcode.

To insure maximum processing speed, processing power is distributed among several internal controllers in addition to the microprocessor 201 and the math processor 207. An additional state machine with 1K byte of microcode is used by a display generator 153 to create a display of both data and display forms from a list in a display RAM 217 which drives the CRT 149 in the display section 218 from a line generator 219 which positions a new X—Y point pair approximately every four microseconds. Likewise both the system bus 145 and the external HP—IB bus 157 have their own internal processors 221 and 223. Finally, controllers 225, 227, and 229 are dedicated to the tape drive 161, the bubble memory 235 within memory 147, and the front panel 159 respectively.

Memory is also distributed according to functional need. 16K bytes of ROM 233 within memory 147 are used for internal test software and boot-up of the system. The main system software is taken from a first 128K bytes of nonvolatile bubble memory 235 within memory 147 and placed into 128K bytes of main RAM 237 also within memory 147. 8K bytes of ROM 239 are dedicated to the bubble memory 235 for use in test and boot-up. 60K bytes from the second 128K bytes of bubble memory 235 are used to store equation coefficients used in vector error correction. The remaining 68K bytes of bubble memory 235 contain recallable instrument states, measurement memory data, and additional system software. The contents of the CRT display are stored in 32K bytes of display RAM 217. The remaining 96K bytes of display RAM 217 are used for data, coefficients, and control tables. Personal back-up storage, test software, additional system software, and data can be stored and accessed as desired on cartridges in the tape drive 241.

Description of the front panel, menus, and displays.

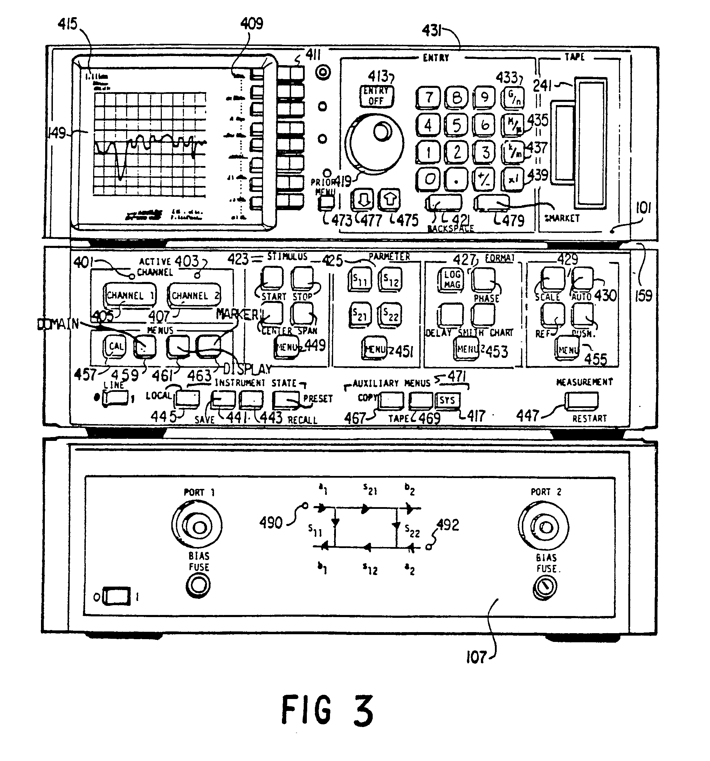

Figure 3 shows the front panel 159 of the present vector network analyzer with capability to set up and control two independent measurements with two measurement channels selected by channel buttons 405 and 407. When an indicator 401 or 403 above the channel buttons 405 and 407 is lit, the respective channel is selected as the channel controlled by the front panel 159. The CRT 149 is also available for viewing on the front panel 159. Annotation on the CRT 149 includes graticules if desired, labels for one or two data traces side by side or overlaid data traces reference line position symbols, and channel labels for the parameter being shown, the format of the display, reference line value, horizontal and vertical scales, and the value of any markers being used. Source frequency or other stimulus information is shown on the CRT 149. An active entry menu area 409 in which no data traces are displayed is also provided on the CRT 149 for identification of the current active functions which may be selected via CRT softkeys 411. The softkeys 411 therefore extend the accessable instrument capabilities by adding selectable functions without adding to front panel complexity. An Entry Off key 413 clears the active entry state. Prompts, indications of instrument functions, procedural instructions, error messages, and procedural advisories also appear on the CRT 149. If a message is important to the measurement, a beep sound signals the operator to look at the message. A title area 415 is also provided for up to 50 characters of information about the measurement being viewed. To use the title function, an Auxiliary Menus System button 417 is pressed, followed by one of the softkeys 411 which will be labeled Title. An RPG (Rotary Pulse Generator) knob 419 is then rotated to positon an arrow symbol below the first letter desired and displayed on the CRT 149. The user then presses a Select Letter softkey 411 and the selected letter will appear in the title area 415. This process is repeated as desired along the desired Space softkeys 411 and Backspace keys 411, terminated with a Done softkey 411 and cleared with a Clear Softkey 411.

All basic measurement functions are controlled by four groups of keys (SPFR) labelled Stimulus 423, Parameter 425, Format 427, and Response 429 which respectively are used to set the stimulus, select the parameter, select the format, and adjust the response for the desired measurement. The Stimulus keys 423 provide direct control of the source 109 to set frequencies, source power, sweep time, and other related functions. The Parameter keys 425 select the parameter to be measured. With the source 109 applied to port 1, $S_{11}$ is selected for reflection (return loss) and $S_{21}$ is selected for transmission (insertion loss or gain). Likewise, with the source 109 applied to port 2, $S_{22}$ is selected for reflection and $S_{12}$ is selected for transmission. Appropriate control of the test set 107 is enabled automatically depending on the parameter selected. The Format keys 427 place measured parameter data in the desired format: logarithmic (dB), phase, group delay, and Smith Chart, or, alternatively, SWR, linear magnitude, R+jX impedance, and others. The Response keys 429 set the scale per division, reference value, or reference position, or let an AUTO function via an Auto key 430 automatically place all the measured data on the entire display 149 with pleasing values for a reference value and scale. Additional Response functions include averaging, smoothing, and an electronic line stretcher.

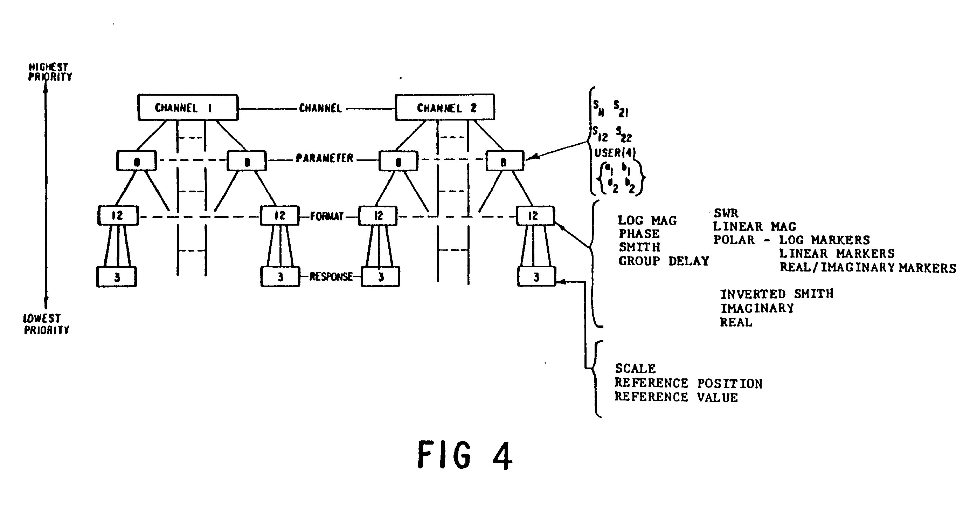

The hierarchical Channel-Parameter-Format-Response (CPFR) operating parameter structure used in the present RF vector network analyzer is shown in Figure 4. Once a particular path through the CPFR structure has been chosen, this path is automatically stored in the memory 147 for later reference. Then, when one of the CPFR structure items is changed, such as changing the Parameter from $S_{11}$ to $S_{22}$, the entire path previously associated with the new item is automatically reestablished for use by the entire system. Thus, for example, if Channel 1 is presently being used to measure the Parameter $S_{11}$ with the display in log magnitude Format and 0.02 dB/division vertical Scale, and if Channel 1 was previously used to measure the Parameter $S_{22}$ with the display in linear magnitude Format and a 5 milliunits/division vertical Scale, then when the Parameter is changed from $S_{11}$ to $S_{22}$ the Format automatically changes from log magnitude to linear magnitude and the Scale automatically changes from 0.2 dB/division to 5 milliunits/division. In addition, since the CPFR structure is an hierarchical tree and since Parameters are lower in the hierarchy than Channels, the Channel number will not be changed when the Parameter is changed as in the present example. Similarly, if the Channel is changed, the Parameter, Format, and Response are all subject to automatic reestablishment, and if only the Format is changed, only the Response is subject to automatic reestablishment. Naturally, any of the CPFR values may be altered from the front panel 159 as desired by the user. The result of this hierarchical CPFR structure is a substantial added degree of speed and convenience for the user.

Numeric Entry keys 431 are used when a numeric value is to be entered, which entered value is terminated by one of four terminator keys G/n 433, M/u 435, k/m 437, and x1 439. The four terminator keys 433—439 are used when the entered value being terminated has the order of magnitude respectively of either Giga ($10^{+9}$) or nano ($10^{-9}$), Mega ($10^{+6}$) or micro ($10^{-6}$), kilo ($10^{+3}$) or milli ($10^{-3}$), or a basic unit ($10^0$) such as dB, degree, second or hertz. The four terminator keys 433—439 are therefore unique in that no particular set of measurement units is permanently assigned to any of the keys, so that substantially fewer terminator keys are required than in the prior art.

Pressing a Save key 441 followed by one of the CRT softkeys 411 saves the current complete state of the network analyzer 101, and the controlled functions of the source 109 and the test set 107. A Recall key 443 followed by a CRT softkey 411 is used to recall the previously stored system state. The hierarchical CPFR structure is an integral part of the system state.

A Tape key 469 in an Auxiliary Menu Block 472 displays labels in area 409 for controlling the internal tape drive 241. The tape functions allow initialization of cassette tapes, storing data to tape, loading data from tape, deleting data on tape, erasing the last deletion of data, and display of a directory of tape contents on the CRT 149. Tape data can be a combination of any of the following:

1. Measurement data after second IF and detector correction (raw data), after error correction and/or time domain conversion (data), or after formatting (formatted data) for either or both measurement channels.

2. Memory data stored after time domain conversion and before formatting from an earlier measurement, individually or all at once.

3. Graphics that the user has created on the CRT 149 (Figure 3).

4. One or all sets of machine states stored by pressing the Save key 441 (Figure 3).

5. One or all sets of error coefficients measured and stored by pressing a CAL key 457, and subsequent Calibrate soft keys 411 labelled in the area 409.

6. One or all sets of calibration standard descriptions (Cal Kits).

7. A complete machine dump consisting of all sets of all data described in 1 through 6.

8. System, service, or demo software, including options, revised versions, and new software.

When measurement data is loaded from tape to any point in the Data Processing path, the display on the CRT 149 is updated to show the loaded data with subsequent data processing.

If an external device has control of the system using the HP—IB interface 157, pressing a Local key 445 returns control of the system to the front panel 159.

A Restart key 447 is used to restart any previously started measurement or data handling operation such as sweeping or averaging.

Three blocks of the front panel keys along with the softkeys 411 provide an additional feature called MENUS for functions which are used less frequently than the functions to which dedicated keys are assigned. Four Menu keys 449, 451, 453, and 455 provide extensions of the SPFR keys 423, 425, 427 and 429; keys labelled Cal 457, Domain 459, Display 461, and Marker 463 in a Menus block allow selection of various measurement and display modes; and keys labeled Copy 467, Tape 469, and System 417 under the Auxiliary Menus block 471 provide measurement related input and output operations.

When a MENU is displayed on the CRT 149 any current choices are indicated by a line under the labels and mutually exclusive and/or closely related choices are connected by dots. Pressing the softkey 411 beside any label in area 409 either executes the function or presents another set of MENU labels. If the selected function requests an input, the RPG knob 419 and Entry keys 431 are used to respond. Additional functions are selected by pressing another key. A Prior Menu key 473 is used to return to the previously displayed MENU in a series of menus. If the previously displayed MENU was the first in a series of MENUS, the MENU is cleared from the CRT 149.

Software signal processing

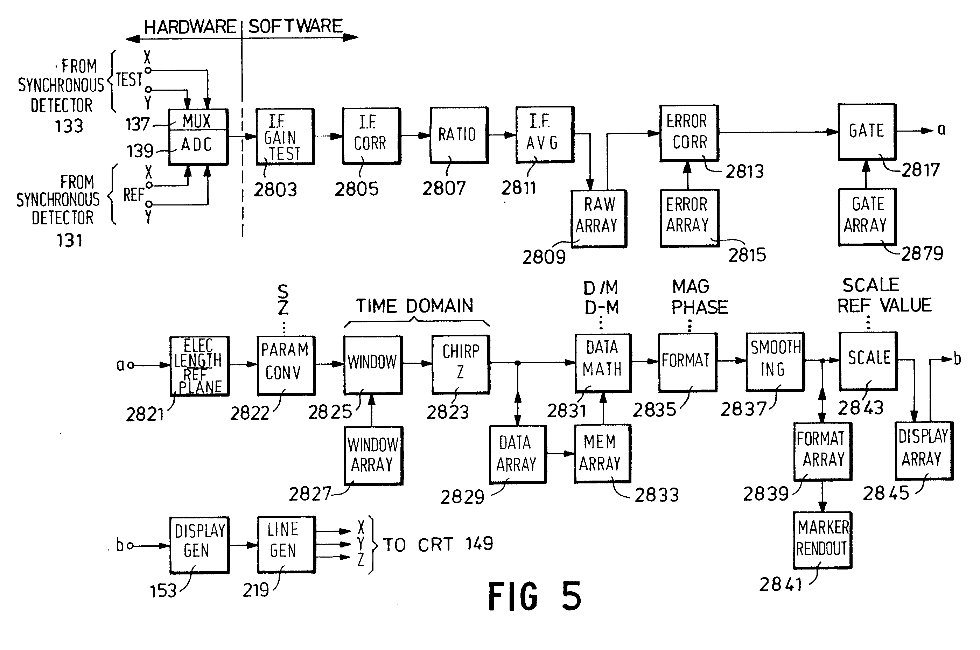

As shown in Figure 5, signal processing in the present RF vector network analyzer begins at the output of the synchronous detector pair 131 and 133 which provide the real (X) and imaginary (Y) parts of the test and reference signals. As explained previously, offset, gain, and quadrature errors are corrected for both of the IF/detector chains via software which is arranged as blocks IF gain test 2803 and IF Correction 2805. The resulting test and reference data is then ratioed in block 2807 to produce the appropriate S-parameters and stored in the Raw Array 2809. If requested by the user, subsequent data taken at the same frequency are averaged together in the IF Averaging block 2811 to lower system noise and thus enhance dynamic range.

While the Raw Array 2809 is continually filled under control of the data acquisition software which will be discussed shortly, the data processing software concurrently removes data from the Raw Array 2809 and performs additional signal processing. Using a one term model (vector frequency response normalization), a three term model (one port model), and up to a twelve term error correction model (comprehensive two port) of the microwave measurement hardware, the Vector Error Correction software 2813 in conjunction with the Vector Math Processor 151 provides corrected data through application of the Error Array 2815 to the Raw Array. Further data manipulation is provided as desired by the user through Gating 2817 along with the separate Gate Array 2879, Electrical Length/Reference Plane Extension 2821, and Parameter Conversion 2822. The corrected data may also be converted from the frequency domain to the time domain using Chirp Z transforms. Windows 2825 and Window Array 2827 are used to remove the ringing in time domain due to band limited frequency domain input signals and then using the Chirp Z transforms 2823 to transform into the time domain. The data in the Data Array 2829 may be stored into memory in the Memory Array 2833 and used in vector computations with data from a second device. Comparisons of present data (D) and memory data (M) is accomplished through vector computations 2831 to provide all four mathematical functions D*M, D/M, D+M, and D−M. Storage of the corrected and processed data D in the Data Array 2829 and the trace math data M in the Memory Array 2833 allows rapid response to the user when making format or trace math changes.

The vector data is then formatted in the Format block 2835 into magnitude, phase, group delay, or other formats as desired. Adjacent formatted points can then be combined if desired in the Smoothing block 2837. The resulting formatted data is stored into the Format Array 2839 which provides convenient access for scale and offset changes provided by the Scale block 2843. Markers are also applied as desired to the formatted data via the Marker Readout block 2841. Scaled data is stored in a Display Array 2845 in the Display Ram 217 from which the display generator 153 hardware repetitively creates a plot on the CRT 149 for a flicker-free display.

Input and output access is provided to and from all of the arrays via the HP—IB interface 157 and via tape 161 with S-parameters available from the Data Array 2829 in addition to other applicable arrays. Direct printer output for the printer 155 is made from the Format Array 2839. Direct plotter output for plotter 155 is made from the Display Array 2845. The user may also trade off the data update rate against the number of data points used by selecting resolutions from 51 to 401 points.

The software is structured as a multi-tasking system to provide a rapid data update rate by allowing data processing to take place when the data acquisition software is not busy. Overlying command and control tasks interleave data processing with data acquisition cycles to provide both two port error correction and dual channel display modes.

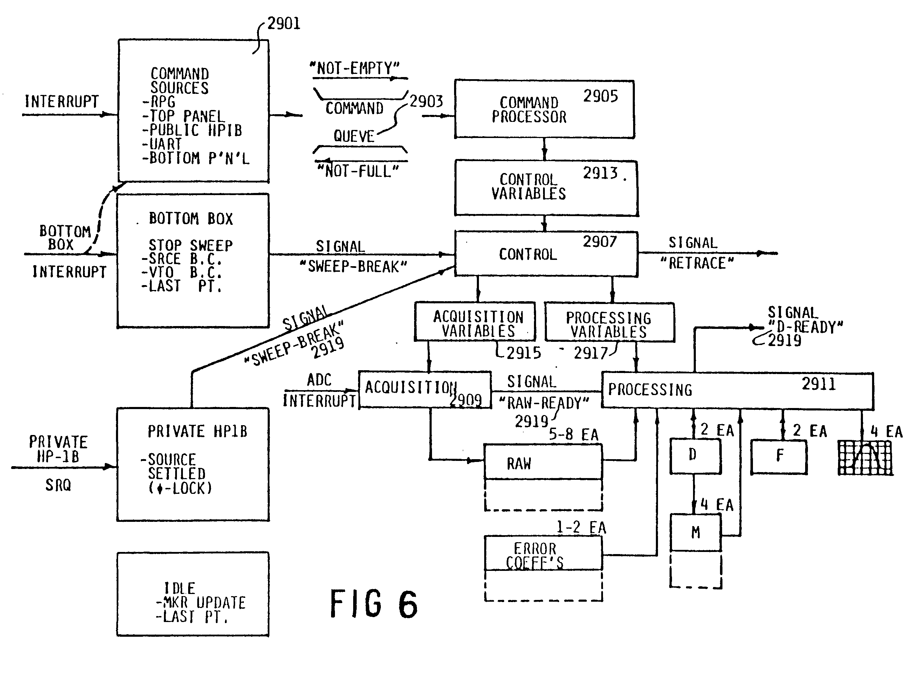

The software signal process discussed previously is controlled by a process structure as shown in Figure 6. This process structure is one of the reasons the present RF vector network analyzer can process RF data essentially in real time. For example, low priority processes such as controlling the source 109, controlling the test set 107, and formatting the display 149 are only performed when the data acquisition process is not busy. Previous systems would take data, process it completely through to the display and when the end of each sweep is reached, the processor had to wait for the hardware to reset. Instead, the present RF vector network analyzer actually performs processing while the control functions such as resetting for a subsequent sweep or while switching S parameter are proceeding. The Command Sources 2901 accept user commands via the front panel 159 and the HP—IB interface 157, parses and converts the commands to a common internal command token regardless of source and puts the commands into a command queue 2903. The Command Processor 2905 takes the commands from the command queue 2903 and implements them. Any one time precomputation that will later improve run time efficiency is done at this time. The Command Processor 2905 modifies the instrument state and performs one time operations, such as updating a trace after a scale change, outputting an array of data, and copying the Data Array into the Memory Array. Based on the instrument state. Control 2907 is responsible for insuring that the desired data is acquired in the specified manner and conditions. This includes control of source 109, test set 107, phase lock 125, IF multiplexers 136, ADC 139, and set up of the data acquisition and processing. Swept and stepped, alternate and chopped, single and continuous signal sweeps are implemented within Control 2907. Sweep maintenance is also managed in the Control 2907 to keep track of bandcrossings and frequency stepping. Acquisition 2909 services the ADC 139 interrupt, IF gain autoranging, ratioing, averaging and storing data into the Raw Array 2809. Processing 2911 processes data from the Raw Array 2809 until the data is displayed on the CRT 149 including vector error correction of external errors, parameter conversion, (gating windowing and transformation), trace math (D*M, D/M, D+M, D−M), formatting (log, linear, and delay), and response (scale, reference value, and split screen).

The machine state variables that are used to drive control variables 2913 include: parameter descriptions such as test set set-up, receiver set-up, and ratio/non-ratio; user selections for frequency, power, sweep time, formats, scale per division, averaging information, number of points to be taken, error correction type, and time domain factors; and, internal housekeeping pointers to the data, raw, error coefficients, corrected data, formatted data, memory data, and display data arrays. Acquisition variables 2915 provide data reduced from the control variables 2913 for efficiency that are related to controlling the ADC 139 until the data is stored in the raw array. The Acquisition variables 2915 include: IF gain receiver error, ratioing, averaging, and current pointer position in the raw array. The Processing variables 2917 provide data reduced from the group control variables for efficiency that are related to controlling the processing of data from the raw array through the display. The Processing variables 2917 include: current position pointers for the arrays, error correction type, time domain information, trace math, format, and response. The Signals 2919 provide synchronization between programs that otherwise function independently of one another.

## Claims

1. An apparatus for saving and recalling measurement configurations of an RF analyzer (101), said measurement configurations made up of at least two of the measurement functions of channel, parameter, format, and response, each of the measurement functions having associated therewith a plurality of configuration elements, and for automatically providing a measurement configuration for said analyzer (101) from said recalled measurement configurations, comprising:

keyboard means (159) for entering measurement configurations;

processor means (143, 147) having a memory (147) coupled to said keyboard means (159) for storing said measurement configurations as a hierarchical tree, said measurement configurations having any of a plurality of first ones of said configuration elements and a plurality of second ones of said configuration elements, at least one of said second configuration elements forming a branch in said hierarchical tree extending from each of said first configuration elements;

said processor means (143, 147), in response to entry of one of said first configuration elements from said keyboard means (159), for selecting one of said branches of said hierarchical tree as an initial second configuration element based upon a previously stored measurement configuration.

2. An apparatus as in claim 1 wherein said hierarchical tree comprises an ordered plurality of levels with one of said plurality of levels comprising said plurality of first configuration elements and another of said plurality of levels comprising said plurality of second configuration elements.

3. An apparatus as in claim 2 wherein said ordered plurality of levels comprises at least one of a channel level ("CHANNEL"), a measurement parameter level ("PARAMETER"), a display format level ("FORMAT"), and a response level ("RESPONSE").

4. An apparatus as in claim 3 wherein in said hierarchical tree said response level ("RESPONSE") comprises a plurality of response functions branching from said display format level ("FORMAT"), said plurality of second configuration elements comprising said plurality of response functions.

5. An apparatus as in claim 4 wherein said display format level ("FORMAT") comprises a plurality of display formats, said plurality of first configuration elements comprising said plurality of display formats.

6. An apparatus as in claim 3 wherein in said hiararchical tree said display format level ("FORMAT") comprises a plurality of display formats branching from said measurement parameter level ("PARAMETER"), said plurality of second configuration elements comprising said plurality of display formats.

7. An apparatus as in claim 6 wherein said measurement parameter level ("PARAMETER") comprises a plurality of measurement parameters, said plurality of first configuration elements comprising said plurality of measurement parameters.

8. An apparatus as in claim 7 wherein said response level ("RESPONSE") comprises a plurality of response functions, and wherein said processor means (143, 147) also selects one of said response functions in response to entry of said one of said first configuration elements from said keyboard means (159) based upon said previously stored measurement configuration.

9. An apparatus as in claim 3 wherein in said hierarchical tree said measurement parameter level ("PARAMETER") comprises a plurality of measurement parameters branching from said channel level ("CHANNEL"), said plurality of second configuration elements comprising said plurality of measurement parameters.

10. An apparatus as in claim 9 wherein said channel level ("CHANNEL") comprises a plurality of channels, said plurality of first configuration elements comprising said plurality of channels.

11. An apparatus as in claim 10 wherein said display format level ("FORMAT") comprises a plurality of display formats, and wherein said processor means (143, 147) also selects one of said display formats in response to entry of said one of said first configuration elements from said keyboard means (159) based upon said previously stored measurement configuration.

12. An apparatus as in claim 11 wherein said response level ("RESPONSE") comprises a plurality of response functions, and wherein said processor means (143, 147) also selects one of said response functions in response to entry of said one of said first configuration elements from said keyboard means (159) based upon said previously stored measurement configuration.

13. An apparatus as in claim 3 wherein said channel level ("CHANNEL") comprises a plurality of channels.

14. An apparatus as in claim 3 wherein said measurement parameter level ("PARAMETER") comprises a plurality of measurement parameters selected from the group consisting of $S_{11}$, $S_{12}$, $S_{21}$, $S_{22}$, a1, a2, b1, and b2.

15. An apparatus as in claim 3 wherein said display format level ("FORMAT") comprises a plurality of display formats selected from the group consisting of logarithmic magnitude, phase, group delay, Smith Chart, SWR, linear magnitude, polar chart, inverted Smith Chart, and $R+jX$ impedance.

16. An apparatus as in claim 3 wherein said response level ("RESPONSE") comprises a plurality of response functions selected from the group consisting of scale per division, reference value, reference position, averaging, smoothing, and electronic line stretcher.

17. An apparatus as in any one of claims 1 to 16, wherein said keyboard means (159) comprises a plurality of segregated sections (405 and 407, 425, 427, 429) with at least one section for each of said levels in said hierarchical tree, and with each of said sections corresponding to a different one of said levels.

18. An apparatus as in claim 17 wherein each section of said plurality of segregated sections (405 and 407, 425, 427, 429) is physically positioned relative to other of said sections in the same order that said ordered plurality of levels comprise said hierarchical tree.

19. An apparatus as in any one of claims 1 to 18, wherein said measurement configurations are alternatively entered by an external device by means of an HP—IB interface (157).

20. An apparatus as in any one of claims 1 to 19 wherein said measurement configurations are alternatively entered from a tape drive (161) by means of a system interface (203) and bus (215).

**Patentansprüche**

1. Vorrichtung zum Speichern und Rückruf von Meßkonfigurationen eines RF-Netzwerkanalysators (101) wobei die Meßkonfigurationen zumindest aus zwei der Meßfunktionen Kanal, Parameter, Format und Empfindlichkeit bestehen, zu welchen jeweils eine Vielzahl von Konfigurationselementen gehören, und zum automatischen Erzeugen einer Meßkonfiguration für den Netzwerkanalysator (101) aus den rückgerufenen Meßkonfigurationen, wobei die Vorrichtung aufweist:

—ein Bedienungsfeld (159) zur Eingabe von Meßkonfigurationen;

—eine Prozessoreinheit (143, 147) mit einem mit dem Bedienungsfeld (159) verbundenen Speicher um die Meßkonfigurationen in hierarchischer Verzweigung zu speichern, wobei die Meßkonfigurationen eines aus einer Vielzahl erster Konfigurationselemente und eine Vielzahl zweiter Konfigurationselemente aufweisen, und mindestens eines der zweiten Konfigurationselemente einen Ast in der hierarchischen Verzweigung bildet, der von jedem der ersten der Konfigurationselemente ausgeht; und wobei

—die Prozessoreinheit (143, 147) auf eine Eingabe eines der ersten Konfigurationselemente an dem Bedienungsfeld (159) einen der Äste der hierarchischen Verzweigung als ein anfängliches zweites Konfigurationselement aufgrund einer zuvor gespeicherten Meßkonfiguration wählt.

2. Vorrichtung nach Anspruch 1, dadurch gekennzeichnet, daß die hierarchische Verzweigung eine grordnete Niveauvielzahl (Fig. 4), in welcher ein Niveau die Vielzahl der ersten Konfigurationselemente und ein anderes Niveau die Vielzahl der zweiten Konfigurationselemente aufweist.

3. Vorrichtung nach Anspruch 2, dadurch gekennzeichnet, daß die geordnete Niveauvielzahl mindestens ein Kanalniveau (Fig. 4 "CHANNEL"), ein Meßparameterniveau (Fig. 4 "PARAMETER"), ein Anzeigeformatniveau (Fig. 4 "FORMAT") und ein Empfindlichkeitsniveau (Fig. 4, "RESPONSE") aufweist.

4. Vorrichtung nach Anspruch 3, dadurch gekennzeichnet, daß das Empfindlichkeitsniveau (Fig. 4; "RESPONSE") in der hierarchischen Verzweigung eine Vielzahl von Empfindlichkeitsfunktionen aufweist, die sich von einem Anzeigeformatniveau (Fig. 4, "FORMAT") verzweigen wobei die zweiten Konfigurationselemente die Vielzahl der Empfindlichkeitsfunktionen aufweisen.

5. Vorrichtung nach Anspruch 4, dadurch gekennzeichnet, daß das Anzeigeformatniveau (Fig. 4, "FORMAT") eine Vielzahl von Anzeigeformaten aufweist, wobei die ersten Konfigurationselemente die Vielzahl der Anzeigeformate aufweisen.

6. Vorrichtung nach Anspruch 3, dadurch gekennzeichnet, daß in der hierarchischen Verzweigung das Anzeigeformatniveau (Fig. 4 "FORMAT") eine Vielzahl von Anzeigeformaten aufweist, die sich von einem Meßparameterniveau (Fig. 4, "PARAMETER") verzweigen, wobei die zweiten Konfigurationselemente die Vielzahl der Anzeigeformate aufweisen.

7. Vorrichtung nach Anspruch 6, dadurch gekennzeichnet, daß das Meßparameterniveau ("PARAMETER") eine Vielzahl von Meßparametern enthält, die ihrerseits in der Vielzahl der ersten Konfigurationselemente enthalten sind.

8. Vorrichtung nach Anspruch 7, dadurch gekennzeichnet, daß das Empfindlichkeitsniveau ("RESPONSE") eine Vielzahl von Empfindlichkeitsfunktionen enthält und die Prozessoreinheit (143, 147) auch eine der Empfindlichkeitsfunktionen in Abhängigkeit von einer Eingabe eines der ersten Konfigurationselemente an dem Bedienungsfeld (159) basierend auf der zuvor gespeicherten Meßkonfiguration wählt.

9. Vorrichtung nach Anspruch 3, dadurch gekennzeichnet, daß das Meßparameterniveau ("PARAMETER") in der hierarchischen Verzweigung eines Vielzahl von Meßparametern enthält, die sich von einem Kanalniveau ("CHANNEL") verzweigen und die zweiten Konfigurationselemente die Vielzahl der Meßparameter aufweisen.

10. Vorrichtung nach Anspruch 9, dadurch gekennzeichnet, daß das Kanalniveau ("CHANNEL") eine Vielzahl von Kanälen enthält, die ihrerseits in der Vielzahl der ersten Konfigurationselemente enthalten sind.

11. Vorrichtung nach Anspruch 10, dadurch gekennzeichnet, daß das Anzeigeformatniveau ("FORMAT") eine Vielzahl von Anzeigeformaten enthält und daß die Prozessoreinheit (143, 147) auch eines der Anzeigeformate abhängig von einer Eingabe eines der ersten Konfigurationselemente an dem Bedienungsfeld (149) basierend auf einer zuvor gespeicherten Meßkonfiguration wählt.

12. Vorrichtung nach Anspruch 11, dadurch gekennzeichnet, daß das Empfindlichkeitsniveau ("RESPONSE") eine Vielzahl von Empfindlichkeitsfunktionen enthält und die Prozessoreinheit (143, 147) auch eine der Empfindlichkeitsfunktionen in Abhängigkeit von einer Eingabe eines der ersten Konfigurationselemente an dem Bedienungsfeld (159) basierend auf einer zuvor gespeicherten Meßkonfiguration wählt.

13. Vorrichtung nach Anspruch 3, dadurch gekennzeichnet, daß das Kanalniveau ("CHANNEL") eine Vielzahl von Kanälen enthält.

14. Vorrichtung nach Anspruch 3, dadurch gekennzeichnet, daß das Meßparameterniveau ("PARAMETER") eine Vielzahl von Meßparametern enthält, die aus der $S_{11}$, $S_{12}$, $S_{21}$, $S_{22}$, a1, a2,

b1 und b2 umfassenden Gruppe ausgewählt sind.

15. Vorrichtung nach Anspruch 3, dadurch gekennzeichnet, daß das Abzeigeformatniveau ("FORMAT") eine Vielzahl von Anzeigeformaten enthält, die aus der logarithmischen Maßstab, Phase, Gruppenverzögerung, Smith-Diagramm, SWR, linearen Maßstab, Polardiagramm, invertiertes Smith-Diagramm und R+jX Impedanz umfassenden Gruppe gewählt sind.

16. Vorrichtung nach Anspruch 3, dadurch gekennzeichnet, daß das Empfindlichkeitsniveau (Fig. 4 "RESPONSE") eine Vielzahl von Empfindlichkeitsfunktionen enthält, die aus der Maßeinheit pro Teilstrich, Bezugswert, Bezugslage, Mittelwertbildung, Dämpfung und elektronische Zeilendehnung umfassenden Gruppe gewählt sind.

17. Vorrichtung nach einem der Ansprüche 1 bis 16, dadurch gekennzeichnet, daß das Bedienungsfeld (159) mehrere gesonderte Abschnitte (405 und 407, 425, 427, 429) mit zumindest einem Abschnitt für jedes der Niveaus in der hierarchischen Verzweigung aufweist, wobei jeder Abschnitt einem anderen Niveau entspricht.

18. Vorrichtung nach Anspruch 17, dadurch gekennzeichnet, daß jeder Abschnitt der gesonderten Abschnitte (405 und 407, 425, 427, 429) relativ zu den anderen Abschnitten eine Position in derselben Ordnung einnimmt, wie die der Niveauvielzahl in der hierarchischen Verzweigung.

19. Vorrichtung nach einem der Ansprüche 1 bis 18, dadurch gekennzeichnet, daß die Meßkonfiguration alternativ mittels eines externen Gerätes über ein HP—IB-Interface (157) eingegeben werden.

20. Vorrichtung nach einem der Ansprüche 1 bis 19, dadurch gekennzeichnet, daß die Meßkonfigurationen alternativ von einem Bandgerät (161) über ein Systeminterface (230) und einen Bus (215) eingegeben werden.

**Revendications**

1. Un appareil pour conserver et rappeler des configurations de mesure d'un analyseur RF (101), lesdites configurations de mesure étant formées d'au moins deux des fonctions de mesure de canal, de paramètre, de format et de réponse, chacune des fonctions de mesure étant associée à une pluralité d'éléments de configuration, et pour établir automatiquement une configuration de mesure pour ledit analyseur (101) à partir desdites configurations de mesure rappelées, comprenant:
—un moyen à clavier à touches (159) pour introduire des configurations de mesure;
—un moyen de traitement (143, 147) comportant une mémoire (147) reliée audit moyen à clavier à touches (159) pour mémoriser lesdites configurations de mesure sous la forme d'une ramification hiérarchique, lesdites configurations de mesure comportant un élément quelconque d'une pluralité de premiers éléments de configuration et d'une pluralité de seconds éléments de configuration, au moins un desdits seconds éléments de configuration formant dans ladite ramification hiérarchique une branche partant de chacun desdits premiers éléments de configuration;
—ledit moyen de traitement (143, 147) intervenant, en réponse à une entrée d'un desdits premiers éléments de configuration à partir dudit moyen à clavier à touches (159), pour sélectionner l'une desdites branches de ladite ramification hiérarchique comme un second élément de configuration initial sur la base d'une configuration de mesure précédemment mémorisée.

2. Un appareil selon la revendication 1, dans lequel ladite ramification hiérarchique comprend un ensemble ordonné de niveau (figure 4) où l'un des niveaux dudit ensemble comprend ladite pluralité de premiers éléments de configuration tandis qu'un autre niveau dudit ensemble comprend ladite pluralité de seconds éléments de configuration.

3. Un appareil selon la revendication 2, dans lequel ledit ensemble ordonné de niveaux comprend au moins un des niveaux suivants: un niveau de canal (figure 4, "CANAL"), un niveau de paramètre de mesure (figure 4, "PARAMETRE"), un niveau de format d'affichage (figure 4, "FORMAT") et un niveau de réponse (figure 4, "REPONSE").

4. Un appareil selon la revendication 3, dans lequel, dans ladite ramification hiérarchique, ledit niveau de réponse (figure 4, "REPONSE") comprend une pluralité de fonctions de réponse partant dudit niveau de format d'affichage (figure 4, "FORMAT"), ladite pluralité de seconds éléments de configuration comprenant ladite pluralité de fonctions de réponse.

5. Un appareil selon la revendication 4, dans lequel ledit niveau de format d'affichage (figure 4, "FORMAT") comprend une pluralité de formats d'affichage, ladite pluralité de premiers éléments de configuration comprenant ladite pluralité de formats d'affichage.

6. Un appareil selon la revendication 3, dans lequel, dans ladite ramification hiérarchique, ledit niveau de format d'affichage (figure 4, "FORMAT") comprend une pluralité de formats d'affichage partant dudit niveau de paramètre de mesure (figure 4, "PARAMETRE"), ladite pluralité de seconds éléments de configuration comprenant ladite pluralité de formats d'affichage.

7. Un appareil selon la revendication 6, dans lequel ledit niveau de paramètre de mesure ("PARAMETRE") comprend une pluralité de paramètres de mesure, ladite pluralité de premiers éléments de configuration comprenant ladite pluralité de paramètres de mesure.

8. Un appareil selon la revendication 7, dans lequel ledit niveau de réponse ("REPONSE") comprend une pluralité de fonctions de réponse, et dans lequel ledit moyen de traitement (143, 147) sélectionne également une desdites fonctions de réponse en réponse à une entrée d'un desdits premiers éléments de configuration en provenance dudit moyen à clavier à touches (159) et sur la base de ladite configuration de mesure précédemment mémorisée.

9. Un appareil selon la revendication 3, dans lequel, dans ladite ramification hiérarchique, ledit niveau de paramètre de mesure ("PARAMETRE") comprend une pluralité de paramètres de mesure partant dudit niveau de canal ("CANAL"), ladite pluralité de seconds éléments de configuration comprenant ladite pluralité de paramètres de mesure.

10. Un appareil selon la revendication 9, dans lequel ledit niveau de canal ("CANAL") comprend une pluralité de canaux, ladite pluralité de premiers éléments de configuration comprenant ladite pluralité de canaux.

11. Un appareil selon la revendication 10, dans lequel ledit niveau de format d'affichage ("FORMAT") comprend une pluralité de formats d'affichage, et dans lequel ledit moyen de traitement (143, 147) sélectionne également un desdits formats d'affichage en réponse à une entrée d'un desdits premiers éléments de configuration en provenance dudit moyen à clavier à touches (159) sur la base de ladite configuration de mesure précédemment mémorisée.

12. Un appareil selon la revendication 11, dans lequel ledit niveau de réponse ("REPONSE") comprend une pluralité de fonctions de réponse, et dans lequel ledit moyen de traitement (143, 147) sélectionne également une desdites fonctions de réponse en réponse à une entrée d'un desdits premiers éléments de configuration en provenance dudit moyen à clavier à touches (159) sur la base de ladite configuration de mesure précédemment mémorisée.

13. Un appareil selon la revendication 3, dans lequel ledit niveau de canal ("CANAL") comprend une pluralité de canaux.

14. Un appareil selon la revendication 3, dans lequel ledit niveau de paramètre de mesure ("PARAMETRE") cmprend une pluralité de paramètres de mesure sélectionnés dans le groupe se composant de $S_{11}$, $S_{12}$, $S_{21}$, $S_{22}$, a1, a2, b1 et b2.

15. Un appareil selon la revendication 3, dans lequel ledit niveau de format d'affichage ("FORMAT") comprend une pluralité de formats d'affichage sélectionnés dans le groupe se composant de grandeur logarithmique, phase, retard de groupe, diagramme de Smith, SWR, grandeur linéaire, diagramme polaire, diagramme de Smith inversé et impédance R+jX.

16. Un appareil selon la revendication 3, dans lequel ledit niveau de réponse (figure 4, "REPONSE") comprend une pluralité de fonctions de réponse sélectionnées dans le groupe se composant de: échelle par division, valeur de référence, position de référence, établissement de moyenne, filtrage de prolongateur de ligne électronique.

17. Un appareil selon une quelconque des revendications 1 à 16, dans lequel ledit moyen à clavier à touches (159) comprend une pluralité de sections séparées (405 et 407, 425, 427, 429), avec au moins une section pour chacun desdits niveaux de ladite ramification hiérarchique, et avec chacune desdites sections qui correspond à un niveau différent parmi lesdits niveaux.

18. Un appareil selon la revendication 17, dans lequel chaque section de ladite pluralité de sections séparées (405 et 407, 425, 427, 429) est physiquement positionnée par rapport aux autres sections précitées dans le même ordre que ladite pluralité ordonnée de niveaux intervenant dans ladite ramification hiéarchique.

19. Un appareil selon une quelconque des revendications 1 à 18, dans lequel lesdites configurations de mesure sont alternativement introduites par un dispositif externe au moyen d'une interface HP—IB (157).

20. Un appareil selon une quelconque des revendications 1 à 19, dans lequel lesdites configurations de mesure sont alternativement introduites à partir d'un appareil à bande (161) au moyen d'une interface de système (203) et d'un bus (215).

FIG 1

FIG 2

EP 0 150 409 B1

FIG 3

EP 0 150 409 B1

HIGHEST PRIORITY

LOWEST PRIORITY

CHANNEL 1 — CHANNEL — CHANNEL 2

$S_{11}$ $S_{21}$
$S_{12}$ $S_{22}$
USER(4)
$\left\{ \begin{matrix} a_1 & b_1 \\ a_2 & b_2 \end{matrix} \right\}$

8 — 8 — PARAMETER — 8 — 8

12 — 12 — FORMAT — 12 — 12

3 — 3 — RESPONSE — 3 — 3

LOG MAG          SWR
PHASE            LINEAR MAG
SMITH            POLAR - LOG MARKERS
GROUP DELAY           LINEAR MARKERS
                      REAL/IMAGINARY MARKERS

INVERTED SMITH
IMAGINARY
REAL

SCALE
REFERENCE POSITION
REFERENCE VALUE

FIG 4

FIG 5

EP 0 150 409 B1

FIG 6